# EUROPEAN PATENT SPECIFICATION

(11) **EP 0 531 764 B1**
(45) Date of publication and mention of the grant of the patent: **22.10.1997**
(21) Application number: 92114138.8
(22) Date of filing: 19.08.1992
(51) Int. Cl.: C08L 79/08, C08K 9/02, C08K 3/04

(54) **Fluorinated carbon polyimide composites**
Fluorierten Kohlenstoff und Polyimide enthaltende Verbundwerkstoffe
Matériaux composites contenant de polyimides et du carbone fluoruré

(30) Priority: 13.09.1991 US 759377
(43) Date of publication of application: 17.03.1993
(73) Proprietor: International Business Machines Corporation, Armonk, N.Y. 10504 (US)
(72) Inventor: Afzali-Ardakani, Ali, Yorktown Heights, N.Y. 10598 (US); Braren, Bodil E., Hartsdale, N.Y. 10530 (US); Daijavad, Shahrokh, Peekskill, N.Y. 10566 (US); Hodgson, Rodney T., Ossining, N.Y. 10562 (US); Molis, Steven E., Yorktown Heights, N.Y. 10598 (US); Viehbeck, Alfred, Stormville, N.Y. 12592 (US)
(74) Representative: Rach, Werner, Dr.

(56) References cited:
- EP-A- 0 355 927
- US-A- 4 957 661
- US-A- 5 098 627

## Description

The technical field of the invention relates to a process for significantly changing the dielectric properties of polyimide composite materials. The dielectric constant of the polyimide composite materials can be lowered for use in electronic packaging applications or raised for use in thin film capacitors. The technical field of the invention also relates to a process for providing a conductive polyimide composite material and especially selective areas that are conductive. Products obtained by the process are also described.

The process and the products of the invention are useful in the manufacture of electronic components and electronic circuits such as microelectronic circuits, printed circuits and circuit boards.

Graphite or a substantially pure form of carbon having a graphitic laminar structure will form a series of compounds in which the graphite structure is retained and which are known in the art as graphite compounds. There are basically two types of these graphite compounds which are referred to as crystal compounds and covalent compounds.

The crystal compounds of graphite can be converted back to the graphite structure because the structure has not been altered to any great extent. These crystal compounds are usually dark colored and are described as lamellar compounds, interstitial compounds or intercalation compounds in that the reactants combine with the graphite in the region between the layers of carbon atoms that are typical in the graphite structure. It has been theorized that the intercalation reaction proceeds because the carbon atoms in the layers are more strongly bonded to one another with weaker bonds between the layers.

Intercalation can occur between each interlayer, alternate interlayers, every third interlayer and the like and typically can be based on alkali metal reactions with graphitic carbon or the reaction of various acids such as red fuming nitric acid, concentrated sulfuric acid and bromine vapor. The latter forms an intercalate C₈Br
which is an electron acceptor in which the electrical resistance decreases, but the Hall coefficient changes from negative to positive (G.R.A. Henning, "Properties of Graphite Compounds," Proceedings of the Second Conference on Carbon, University of Buffalo, N.Y. 1956).

Unlike Bromine intercalate compounds, fluorine forms covalent compound with carbon. When fluorine reacts with amorphous forms of carbon such as wood charcoal it forms carbon tetrafluoride and other fluorocarbons. On the other hand the reaction of fluorine with high-purity carbon or graphite results in the production of polycarbon monofluoride having the formula (CFₓ)ₙ where x varies from about 0.07 to about 1.3 ( Ruff et al., Z. Anorg. Chem., 217,1(1934); Lagow et al., US Patent 3,674,432; Kirk-Othmer, Encyclopedia of Chemical Technology Third Edition, Vol. 10, p. 637).

Chung, U.S. Patent 9,546,892 describes the combination of a thermoset polyimide("Skybond® 700 TN," Monsanto Corp.)in combination with graphite flakes intercalated with bromine. Upon heat-curing the mixture, the intercalated graphite flakes are exfoliated, which is a sudden increase in the dimension of the flakes perpendicular to the carbon layers of the intercalated graphite thereby forming vermicular or wormlike shapes. The composite thus obtained may optionally be heated to carbonize the mixture which results in a composite with a resistivity lower than that of the original composite. A reduction of resistivity as high as a factor of six can be obtained.

Vogel et al., U.S. Patent 4,414,142 describe a highly conductive composite of an organic polymer in combination with an intercalation compound of graphite. The intercalation compound is formed by reacting graphite with a Bronsted acid such as hydrogen fluoride and a metal halide such as PF₅,AsF₅ or SbF₅. The patentee notes that the composite has the mechanical properties of the organic polymer and that the electrical conductivity is increased by a factor of about 100. It is also noted that the conductivity of the composite can be significantly improved by the use of "p" type dopants such as SbF₅, AsF₅ bromine and iodine.

Homsy, U.S. Patent 4,118,532 describes a composition for in vivo implantation consisting of perfluorinated high polymer in combination with a filler element such as fluorinated carbon particles.

Forrest, et al., U.S. Patent 4,511,445 describe a process for improving the conductivity of carbon-containing materials by bombarding the materials with a high energy ion beam to break down the material into amorphus carbon having high conductivity. Conducting lines can be produced in the material as well as vertical contacts through the material as well as vertical contacts through the material where it is employed as a film or coating on a substrate.

Lyons et al. U.S. Patent 4 691 091 describe a process for carbonizing a polymeric material followed by electroplating a metal on the carbonized surface.

In the European Patent Application EP-A-0 299 785 a process of preparing a wear resistant solid film lubricant is disclosed being composed ofa polyimide derived from 2,2-bis[4-(4-aminophenoxy)phenyl]hexafluoropropane and an aromatictetracarboxylic acid or dianhydride or ester thereof containing fluorinated carbon. This wear resistant solid film lubricant having excellent wear characteristics and adhesion is coated on surfaces which have substantially continuos frictional contact, e.g. reciprocating engine parts especially pistons. The area to which the wear resistant lubricant film is bonded is the piston skirt, i.e. all or a portion of the area below the piston rings.

Japanese Patent Application Kokai JP 60 115 622 (Chem. Abs., Vol. 103, 1985 161556w) is directed to an epoxy composition containing fluorinated carbon having excellent insulating properties and useful in sealing electronic parts. In the preferred embodiment, a cresol novolak epoxy resin is mixed with a fluorinated carbon material, a hardener, silica, wax, carbon black and a silane coupling agent followed by kneading, and cooling. The cool mixture is pulverized and employed as a molding powder which can be molded at 180°c for about three minutes followed by post-curing at this temperature for eight hours.

NASA Case No. LEW-14472-1 which comprises subject matter available for licensing in accordance with 14 C.F.R. §1245.2 describes improved graphite fluoride fibers produced by a contact reaction between highly graphitized fibers and fluorine gas. The fibers are preferably intercalated with bromine or fluorine and methyl fluoride prior to fluorination. The graphite fluoride fibers are bound by an epoxy or alternatively polytetrafluoroethylene or a polyimide resin. The resulting composites have high thermal conductivity, high electric resistivity and high emissivity. The invention is further described in Hung, U.S. patent application, Serial No. 251,499, filed September 30, 1988.

The use of polyimides in electronic packaging technology is widely known, the polyimide employed in this respect generally comprising the reaction product of pyromellitic dianhydride (hereafter "PMDA") and 4,4'-oxydiphenylene diamine (hereafter "ODA"). This polymer has most of the desired characteristics which are needed in packaging, namely very high temperature resistance (above 400°C) and a low dielectric constant (ca 3.0-3.5) as well as good mechanical strength. Although adhesion to metals used in printed circuit boards and high-end packaging (such as copper, gold and the like) is poor it can be improved either by surface treatment of the polyimide film such as for example by plasma etching, and\or by introducing an adhesion promoting intermediate layer of chromium. Another factor which limits the use of this polyimide, especially in high wiring density packaging is the thermal expansion mismatch of the polymer with metals (usually copper), semiconductor materials (such as silicon) and packaging materials such as glass or ceramic materials due to the relatively high TCE. The TCE of polyimide derived from PMDA-ODA is so high (450 x 10⁻⁷/°C), that during the fabrication process of thin film packages where a thick polyimide film is bonded to silicon, glass ceramic or even alumina substrates either the substrate warps to an unacceptable level or the polyimide peels off or cracks.

The speed of electrical signals propagated along metal lines imbedded in the polyimide dielectric is determined substantially by the dielectric constant of the polyimide. Reducing the dielectric constant results in an increase in speed of such signals and a decrease in delay time between operation of devices connected by such metal lines.

It is at times advantageous to have an insulating material with high dielectric constant for use as dielectric material in capacitors. More energy can be stored if dielectric constant is larger.

When employing polyimides in electronic packaging or in the manufacture of circuit boards and especially printed circuit boards, it is also desirable to readily form conductive regions or lines for interconnecting circuit elements. Where several circuit boards are stacked and laminated to one another they are generally connected by through holes which are plated by a process known as through hole plating or PTH processes which are well known in the art. Where the circuit boards comprise composites of polyimides and fiber reenforcing materials (e.g. glass fibers) the polyimide surface has to be chemically treated or "roughened" prior to forming the conductive regions or lines.
These conductive regions or lines are generally formed by an electroless coating process comprising the application of a zero-valent palladium catalyst in combination with a protective tin colloid which adheres to the treated polyimide surface after which an electroless metal coating solution comprising a metal salt in combination with an aldehyde reducing agent is applied. The colloidal palladium activates the aldehyde reducing agent and thereby converts the dissolved metal salt, such as copper sulfate to solid copper metal. These electroless coatings are further built up by subsequent electrolytic metal coatings, again all of these processes being well known in the art.

The difficulties with the electroless coating of polyimide surfaces is not only the surface preparation required but also the multiple cleaning and rinsing steps involved in the application of the electroless coating as well as the subsequent processing steps required for building the electrolytic coating.

Accordingly, it is an object of the present invention to overcome these and other difficulties encountered in the prior art.

It is in particular an object of the invention to provide a process for reducing or enhancing the dielectric constant of polyimide material.

These problems are solved by the features of claims 1, 2 and 9. Further improvements are present in claims dependent thereon.

The invention and improvements also meet advantageously the following objects:

It is also an object of the invention to provide a process for effecting a change of the physical properties of a polyimide material.

It is a further object to the present invention to provide a process for reducing the TCE of a polyimide material.

It is a further object of the present invention to provide a process for forming an electrically conductive polyimide composite material from a non-conductive polyimide composite material.

It is also an object of the invention to provide a process for forming at least one conductive region in a polyimide composite material adjacent to a non-conductive region in such polyimide composite material.

It is further object of the present invention to provide a process for electrolytically forming a metal coating on a polyimide composite material where the polyimide composite material has not been coated with an electroless metal coating.

It is the further object of the invention to provide novel products produced by the aforesaid processes.

These and other objects have been achieved according to the present invention which is a composition of matter comprising a fluorinated particulate carbon material dispersed in a polyimide polymer material, the fluorinated carbon material being present in an amount sufficient to substantially reduce the TCE of the polyimide and in an amount also sufficient to substantially change the dielectric constant of the composition.

In one embodiment the polyimide composite is made by dispersing from about 20% to about 50% by weight of a fluorinated carbon which is made by the direct fluorination of carbon powder with fluorine, and containing fluorine in an amount up to about 75 atomic weight percent fluorine in a solution of a polyimide precursor e.g. a polyamic acid in NMP (N-methylpyrrolidone) solvent. Coupling agents such as organo silicons or organo titanates can be employed to enhance the dispersion of the fluorinated carbon in the polyimide solution. The mixture is coated onto a substrate by spin coating or doctor blade, the substrate comprising a silicon wafer, a metal film such as a copper film or ceramic packaging module. The film is dried and cured at a high temperature to obtain a fully imidized polyimide-fluorinated carbon composite.

A composite may also be made from a soluble and fully imidized polyimide such as Polyimide XU 218®, Ciba Geigy Co. or soluble polyetherimides.

Polyimide XU 218 is a polyimide based on diaminophenylindane (DAPI) and benzophenone in dianhydride (BTDA) and is further described in Polyimides edited by Feger et al. Elsevier (1989) p. 497 et seq., and Bateman et al. U.S. Patent 3,856,752.

Where soluble polyimides are employed the fluorinated carbon can be dispersed in a solution of such polyimide or polyetherimide in a solvent and then coated on to a substrate and dried at temperatures above the boiling point of the solvents. No high temperature curing of this film is necessary.

The polyimide-fluorinated carbon composites have a micro-roughness which increases their adhesion to metals by increasing the mechanical interlocking of the metals to the composite surface. Because the surface of the composite is rich in fluorine, the composites will have a higher contact angle with water which helps to prevent or reduce the under cutting of metal lines in high humidity or upon immersion in aqueous solutions employed in subsequent processing steps.

When the foregoing polyimide composite is coated onto a silicon substrate and cured, it can be subsequently irradiated with a UV excimer laser, the electrical resistivity of the exposed area decreases from 10¹⁵ to 10¹-10⁴ ohm/cm. The exposed area can be electroplated with copper which will produce copper plating on the exposed area thereby eliminating many of the processing steps in coating polyimides with an electroless metal followed by applying an electrolytic metal coating.

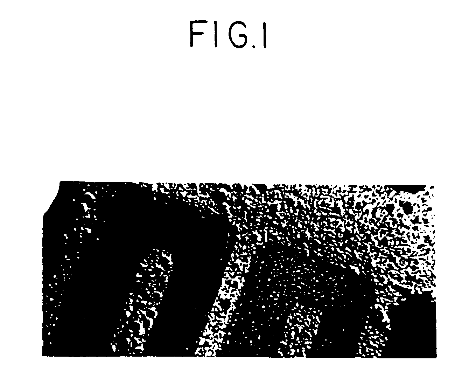

Fig. 1 is a photomicrograph of a polyimide composite of the present invention which has been irradiated with a UV excimer laser to form a conductive pattern which has been subsequently subjected to copper electroplating.

The present invention is directed to a composition of matter comprising a fluorinated particulate carbon material dispersed in a polyimide polymer material were the polyimide comprises a polyamic acid polyimide precursor or a substantially imidized polyimide, i.e, a polyamic acid that has been substantially imidized to a polyimide or a solvent soluble polyimide such as polyimide XU 218® or soluble polyetherimides.

In addition to the PMDA-ODA polyimides that may be employed according to the present invention, those based on bis-(phenylene dicarboxylic acid) anhydride and p-phenylenediamine (hereafter BDA-PDA) can be employed as well as those based on benzophenone tetracarboxylic acid dianhydride and 1,3-bis-(2-aminophenoxy) benzene (hereafter BTDA-APB).

The various art known polyimides which can be used according to the invention, are further described in Kirk-Othmer, Encyclopedia of Chemical Technology, Third Edition(Vol. 18, pp.704-719), Dunphy et al., U.S. Patent 3,770,573; Lindsey, U.S. Patent 3,361,589; Goff, U.S. Patent 4,416,973; Fyrd et al., U.S. Patent 4,551,522; Araps et al., U.S. Patent 4,871,619 columns 3-6 including polyisoimides and THERMID®, Roark et al., U.S. Patent 4,859,530 describing fluorinated polyimides, which along with THERMID® polyimides are useful in adhesive applications and Higuchi et al., Chem. Mater., 1991, 3, 188-94.

The fluorinated carbon material comprises by way of example, ACCUFLUOR® 2065, 3000, 1030 Allied Signal Co. which are produced by direct fluorination of carbon powder, graphite powder or coke respectively. The properties of such fluorinated particles are described by Mathew H. Luly in J.Mater. Res.3, 890-898 (1988).

As noted, the polyimide composite is made by dispersing from about 20% to 50% by weight of a fluorinated carbon having a fluorine/carbon atomic ratio up to about 1.3 (about 75 atomic weight%) in a solution of the polyimide precursor or the soluble polyimide e.g. a polyetherimide, a polyisoimide or a polyamic ester in a suitable solvent. Fluorinated carbon CFₓ where X= 0.07, 0.25 and 1.2 (10, 28 and 64 atomic wt. percent fluorine) are especially suitable, especially those fluorinated carbons having from about 28 to about 64 atomic percent fluorine.

Various coupling agents that may be employed to enhance the dispersion of the fluorinated carbon in the polyimide solution comprise those based on organo silicon or organo titanate compounds known in the art.

The various silicon and titanate compounds that may be employed in this regard are as follows:
trimethylchlorosilane
dimethyldichlorosilane
hexamethyldisilazane
chloromethyldimethylchlorosilane
N,N'-bis(trimethylsilyl)urea
N-trimethylsilyldiethylamine
N-trimethylsilylimidazole
N,O-bis(trimethylsilyl)trifluoroacetimide
N-methyl-N-trimethylsilyltrifluoracetamide
t-butyldimethylsilylimadazole
N-trimethylsilylacetamide
trimethylsilyl iodide
methylchlorosilanes
octadecyltrichlorosilane
octyl-,phenyl-,cyclohexyl-,or ethylsilanes
(3,3,3-trifluoropropyl)trimethoxysilane
[3-(2-aminoethyl)aminopropyl]trimethoxysilane
cyanoethyltrimethoxysilane
aminopropyltriethoxysilane
phenyltrimethoxysilane
(3-chloropropyl)trimethoxysilane
(3-mercaptopropyl)trimethoxysilane
(3-glycidoxypropyl)trimethoxysilane
vinyl-tris (β-methoxyethoxy) silane
(γ-methacryloxypropyl)trimethoxysilane
[γ-(β-aminoethylamino)-propyl]trimethoxysilane vinylbenzyl cationic silane
(4-aminopropyl)triethoxysilane
[γ-glycidoxypropyl)trimethoxysilane
[β-(3,4-epoxycyclohexyl)-ethyl]trimethoxysilane
(β-mercaptoethyl) trimethoxysilane
(γ-chloropropyl)trimethoxysilane
octadecyl-3-(trimethoxysilyl)propylammonium chloride
methylaminopropyltrimethoxysilane
3-(trimethoxysilyl)propyldimethyloctadecylammonium chloride
N-(3-silylpropyl)-p-nitrobenzamide

Examples of titanate coupling agent of the present invention include:
isopropyltridodecylbenzene sulfonyl titanate
isopropyltris(dioctylpyrophosphate) titanate
bis(dioctylpyrophosphate) oxyacetate titanate
bis(dioctylpyrophosphate) ethylene titanate
isopropyltri(dioctylphosphate)titanate
isopropyltri(N-aminoethyl)titanate and mixtures thereof.

As noted previouslv the TCE of polyimides derived from PMDA-ODA is about 450 x 10⁻⁷/°Cand when a thick polyimide is employed in thin film packaging by bonding the polyimide to silicon, glass ceramic or even an alumina substrate, such substrate will warp to an unacceptable level or the polyimide peels or cracks. The fluorinated carbon material is employed in an amount effective to reduce the TCE from anywhere from about 20% to about 90% and especially from about 60% to about 80% where the polyimide film is from about 1µm to about 100µm and especially from about 5µm to about 20µm.

Similarly, the amount of fluorinated carbon employed in the composites of the present invention is such that the dielectric constant can be reduced from anywhere from about 5% to about 40% and especially from about 10% to about 25%.

When a film is formed from either a polyimide precursor such as polyamic acid (or esters thereof) or from a preimidized soluble polyimide (or polyisoimide) heated to 150-250°C to remove the solvent, and irradiated with light from a UV excimer laser, with a wavelength of 248 or 308 nm, the exposed surface area becomes electrically conductive and can be electroplated by techniques well known in the art.

In those applications where the polyimide composite is employed in a circuit board, through holes in the board can be rendered conductive by exposing them to radiant energy as described herein. These through holes can then be electroplated by techniques known in the art.

Additionally, the composites of the present invention may be used as coatings on substrates, especially microelectronic substrates as a dielectric layer, and after application the surface of the composite can be rendered conductive as described herein in order to form surface conductive regions on the substrate. These conductive regions may be produced as described herein by irradiating the substrate through a mask in contact with the substrate or projecting the light transmitted through a mask onto the substrate by techniques that are known in the art. Alternatively, the coating may be screened on the substrate in a pattern, and the coating surface may be rendered conductive by uniform irradiation with an UV excimer laser.

When a radiant energy source is used such as a UV excimer laser, a fluency from anywhere about 10mJ/cm² to about 100mJ/cm² and especially from about 20mJ/cm² to about 50mJ/cm² at a repetition rate from about 2Hz to about 300Hz and especially from about 20Hz to about 100Hz.

The wave length of the UV light can be anywhere from about 193nm to about 350nm and especially from about 248nm to about 308nm. The wave length, fluency and repetition rate are variables that will depend on the polyimide, and amount and nature of the fluorinated carbon all of which are variables that can be readily adjusted within the foregoing ranges by a person with ordinary skill in the art.

It has also been discovered according to the present invention that when polyimide precursors such as polyamic acid are used to form the composite materials of this invention, if the temperature is raised slowly to the normal curing temperature for polyimides (400°C) the composite material will exhibit a higher dielectric constant.

In order to obtain the high dielectric constant composites, with the dried polyimide composite, it is heated slowly to temperatures from room temperature (about 20°C) to about 350 to about 450°C and especially from about 380 to about 400°C for a period of time from about 10 to about 120 minutes and especially from about 40 to about 80 minutes. Slow heating comprises heating at a rate of from about 5^{o}C to about 45°C per minute, and especially from about 10^{o}Cto about 35°C per minute.

When preimidized soluble polyimides or polyisoimides are used to form the composite materials of this invention, after substrate coating and solvent evaporation the dielectric constant of the composite is low and does not change appreciably upon raising the temperature to 400°C. Also, if the composite materials are formed from a polyimide precursor such as polyamic acid, heated at a low temperature (about 150°C to about 200°C) to remove the solvent, and subsequently heated rapidly (within about 2 to about 30 seconds) to a high temperature of 400°C the resulting polyimide composite material exhibits low dielectric constant. These heating rates therefore will be from about 65^{o}cto about 220°C per second and especially from about 75° to about 150°C per second.

Thus, by the expedient of adjusting the curing time and temperatures the composites of the present invention can be converted into high or low dielectric constant products.

The exposure temperature and time depends on film thickness which again will be anywhere from about 1µm to about 100µm and especially from about 5µm to about 20µm.

The following examples are illustrative.

### Example I:

Accufluor® 2CFx 2065 ( Allied Signal Co.) (3.5 grams) was added to 70.0 grams of a 10% solution of soluble polyimide XU 218® in NMP containing 0.2 grams organotitanate coupling agent KRTTS® (Kenrich Chemical Co.) and the mixture was milled for one hour in a glass jar using glass media on a Red Devil shaker. The milled mixture was then separated from the media and let down with various amounts of the polyimide solutions to make mixtures of from 10 phr (parts by weight fluorinated carbon per hundred parts by weight polyimide) to 50 phr and each coated on an aluminum substrate to a thickness of 25-50 microns. The samples were dried and heated at 250° C for 2 hours. The dielectric constant of the samples decreases as the percentage of the fluorocarbon in the composite increases as noted in table 1.

**Table I**

| phr Accufluor® | dielectric constant |
|---|---|
| 0 | 4 |
| 20 | 3.7 |
| 30 | 3.55 |
| 40 | 3.21 |

Upon further heating of these samples to 400°C, no appreciable change of dielectric constant was observed.

### Example II:

Accufluor® 2065 (5.7 grams) was added to a solution of 16.0 grams polyimide 2065 precursor polyamic acid derived from PMDA-ODA in 264 grams NMP solvent. Then 2.5 grams of 4% LICA 12 organotitante [neopentyl(diallyl)oxy,tri(dioctyl) phosphatotitanate] coupling agent was added and the mixture was stirred for half an hour and then milled using glass media for one hour. The milled mixture was let down with additional polyamic acid solution to get 20 phr and 40 phr samples. The samples were then coated on an aluminum substrate, dried at 90°C for 2 hours and then cured in a vacuum oven at 250°C for two hours.

The dielectric constant was measured and the following results obtained:

**Table II**

| phr Accufluor® | Dielectric Constant |
|---|---|
| 0 | 3.52 |
| 20 | 3.13 |
| 40 | 2.61 |

After measurement, the temperature of these samples was raised to 400°C at the rate of 3°C/minute, and kept at 400°C for one hour and cooled to room temperature. The data in Table III were obtained.

**Table III**

| Accufluor® phr | Dielectric Constant |
|---|---|
| 0 | 3.5 |
| 20 | 18.2 |
| 40 | 65.6 |

### Example III:

A polyimide composite with fluorinated carbon (Accufluor® 2065, Allied Signal Co.) was made by dispersion of the fluorinated carbon from 10-15% by wt. in polyamic acid derived from PMDA-ODA solution in NMP and coating the latter on a silicon substrate and curing. The composite was then irradiated with an UV excimer laser. In the example shown in Fig. 1, the wavelength of the UV light was 308 nm, the fluency was 30 mJ/cm² and the repetition rate 20 Hz. The area in Fig. 1 represents the exposed areas with 50 micron width, which exhibited a resistance of 2400ohms when probes were placed 5mm apart on the surface of the exposed lines.

The wavelength, fluency and repetition rate are all variables that depend on the polyimide, percent and nature of fluorinated carbon. In the next step the exposed sample was subjected to a standard copper sulphate electroplating bath at 5-50 mA which resulted in plating of the exposed area with copper (area 2 in Fig. 1.) The polyimide-based substrate is thereby directly and selectively patterned with metals with high resolution and good adhesion of the metal to polymer. This approach takes less time than the existing methods in the fabrication of the thin film packages.

### Example IV

A dispersion of 20 phr Accufluor® 2065 in a solution of polyamic acid derived from PMFD-ODA was prepared according to the procedure of Example II. After coating on a substrate and driving off the solvent at 200°C for 2 hours, the substrate was heated on a 400°C hot plate for 2 seconds. The Fourier transform infrared spectrum showed that the resulting film was almost fully (greater than 98%) imidized. The dielectric constant of the film was measured to be 3.2, very little different from the dielectric constant of a similar film cured at 250°C as in Example II, Table II, and quite different from the film heated slowly to 400°C as shown in Table III of Example II.

## Claims

1. The use of 2 to 50 percent by weight of a fluorinated particulate carbon material dispersed in a polyimide polymer material for electronic circuits or components, wherein the fluorinated carbon material is dispersed in the composition so as to reduce or increase the dielectric constant of the polyimide polymer material.

2. Electronic component or circuit
characterized by a composition of matter containing 2 to 50 percent by weight of a fluorinated particulate carbon material dispersed in said polyimide polymer material.

3. Electronic component or circuit according to claim 2, characterized in that
said polyimide polymer material is formed from polymeric acids or esters of polyimidic acids.

4. Electronic component or circuit according to claim 3, characterized in that
said polyimidic material is based on
PMDA-ODA, which is the reaction product of pyromellitic dianhydride and 4,4-oxydiphenylene diamine;
BDA-PDA, which is bis- (phenylene dicarboxylic acid) anhydride and p-phenylenediamine;
or BTDA-APB, which is benzophenone tetracaeboxylic acid dianhydrine and 1,3-bis- (2-aminphenoxy) benzene.

5. Electronic component or circuit according to anyone of claims 2 to 4, characterized by a conductive pattern, generated in the composite by irradiation with an UV pulsed laser, being subsequently subjected to copper electroplating.

6. Electronic component or circuit according to anyone of claims 2 to 5, characterized in that said fluorinated carbon material contains up to 75 atomic wt% of fluorine.

7. Electronic component or circuit according to anyone of claims 2 to 6, characterized in that
the composition of matter comprises a coupling agent to increase the dispersion of said fluorinated carbon material in the precursor of said polyimide material.

8. Electronic component or circuit of claim 7, characterized in
that the coupling agent is an organo silicon compound or an organo titanium compound.

9. A process of fabricating an electric circuit or component comprising a polyimide polymer material according to anyone of claims 2 to 8, characterized by dispersing fluorinate particulate carbon material in said polyimide polymer material in an amount from 2 to 50 percent by weight and heating said composite material to a temperature of 350°C to 450°C at a rate of 5°C to 45°C per minute to increase the dielectric constant, or heating it rapidly, in particular to a temperature of 400°C at a rate from 65°C to 220°C per second, to decrease the dielectric constant.

10. The process according to claim 9,
characterized by
irradiating said polyimide composite material with a pulsed UV laser to form a polyimide composite material with at least one surface conductive region in said polyimide composite material containing a fluorinated carbon material

11. The process according to claim 10, characterized in that said composite material is selectively irradiated with said pulsed UV laser to provide at least one surface conductive region adjacent to a non-conductive region in said composite material.

12. The process according to anyone of claims 10 to 11, characterized by forming an electrolytic metal coating on said surface conductive region.

## Patentansprüche

1. Verwendung von 2 Gewichtsprozent bis 50 Gewichtsprozent eines fluorierten, partikulären Kohlenstoffmaterials, das in einem Polyimid-Polymermaterial dispergiert ist, für elektronische Schaltungen oder Komponenten, wobei das fluorierte Kohlenstoffmaterial in der Zusammensetzung derart dispergiert ist, daß die Dielektrizitätskonstante des Polyimid-Polymermaterials reduziert oder erhöht wird.

2. Elektronische Komponente oder Schaltung,
gekennzeichnet durch eine Materialzusammensetzung, die 2 Gewichtsprozent bis 50 Gewichtsprozent eines fluorierten partikulären Kohlenstoffmaterials enthält, das in dem Polyimid-Polymermaterial dispergiert ist.

3. Elektronische Komponente oder Schaltung gemäß Anspruch 2, dadurch gekennzeichnet, daß
das Polyimid-Polymermaterial aus polymeren Säuren oder Estern von Polyimidsäuren gebildet ist.

4. Elektronische Komponente oder Schaltung gemäß Anspruch 3, dadurch gekennzeichnet, daß
das Polyimidmaterial basiert auf
PMDA-ODA, welches das Reaktionsprodukt von Pyromellithsäuredianhydrid und 4,4'-Oxydiphenylendiamin ist;
BDA-PDA, das Bis-(phenylendicarbonsäure)anhydrid und p-Phenylendiamin ist;
oder BTDA-APB, das Benzophenontetracarbonsäuredianhydrid und 1,3-Bis-(2-aminphenoxy)benzen ist.

5. Elektronische Komponente oder Schaltung gemäß irgendeinem der Ansprüche 2 bis 4, gekennzeichnet durch eine leitfähige Struktur, die in dem Verbundwerkstoff durch Bestrahlung mit einem gepulsten UV-Laser erzeugt und nachfolgend einem Kupfer-Elektroplattiervorgang unterworfen wird.

6. Elektronische Komponente oder Schaltung gemäß irgendeinem der Ansprüche 2 bis 5, dadurch gekennzeichnet, daß das fluorierte Kohlenstoffmaterial bis zu 75 Atomprozent Fluor enthält.

7. Elektronische Komponente oder Schaltung gemäß irgendeinem der Ansprüche 2 bis 6, dadurch gekennzeichnet, daß
die Materialzusammensetzung ein Kopplungsagens beinhaltet, um die Dispersion des fluorierten Kohlenstoffmaterials in dem Vorprodukt des Polyimidmaterials zu erhöhen.

8. Elektronische Komponente oder Schaltung nach Anspruch 7, dadurch gekennzeichnet,
daß das Kopplungsagens eine organische Silicium-Verbindung oder eine organische Titan-Verbindung ist.

9. Verfahren zur Herstellung einer ein Polyimid-Polymermaterial enthaltenden, elektrischen Schaltung oder einer Komponente gemäß irgendeinem der Ansprüche 2 bis 8, gekennzeichnet durch Dispergieren von fluoriertem partikulärem Kohlenstoffmaterial in dem Polyimid-Polymermaterial in einer Menge von 2 Gewichtsprozent bis 50 Gewichtsprozent und Erwärmen des Kompositmaterials auf eine Temperatur von 350 °C bis 450 °C mit einer Rate von 5 °C pro Minute bis 45 °C pro Minute, um die Dielektrizitätskonstante zu erhöhen, oder schnelles Erwärmen desselben, insbesondere auf eine Temperatur von 400 °C mit einer Rate von 65 °C pro Sekunde bis 220 °C pro Sekunde, um die Dielektrizitätskonstante zu verringern.

10. Verfahren gemäß Anspruch 9, gekennzeichnet durch
Bestrahlen des Polyimid-Kompositmaterials mit einem gepulsten UV-Laser, um ein Polyimid-Kompositmaterial mit wenigstens einem leitfähigen Oberflächengebiet in dem Polyimid-Kompositmaterial zu bilden, das ein fluoriertes Kohlenstoffmaterial enthält.

11. Verfahren gemäß Anspruch 10, dadurch gekennzeichnet, daß das Kompositmaterial selektiv mit dem gepulsten UV-Laser bestrahlt wird, um wenigstens ein leitfähiges Oberflächengebiet angrenzend an ein nicht-leitfähiges Gebiet in dem Kompositmaterial bereitzustellen.

12. Verfahren gemäß irgendeinem der Ansprüche 10 bis 11, gekennzeichnet durch Bilden einer Elektrolytmetallbeschichtung auf dem leitfähigen Oberflächengebiet.

## Revendications

1. Utilisation d'un matériau à base de particules de carbone fluoruré en une quantité de 2 à 50 pour-cent en poids, dispersé dans un matériau polymère polyimide destiné à des circuits ou des composants électroniques, dans lequel le matériau à base de carbone fluoruré est dispersé dans la composition, de manière à réduire ou à augmenter la constante diélectrique du matériau polymère polyimide.

2. Composant ou circuit électronique caractérisé par une composition de matière contenant de 2 à 50 pour-cent en poids d'un matériau à base de carbone particulaire fluoruré dispersé dans ledit matériau polymère polyimide.

3. Composant ou circuit électronique selon la revendication 2, caractérisé en ce que
ledit matériau polymère polyimide est constitué à partir d'acides ou d'esters polymériques d'acides polyimidiques.

4. Composant ou circuit électronique selon la revendication 2, caractérisé en ce que
ledit matériau polyimidique est basé sur du
PMDA-ODA, qui est le produit de la réaction du dianhydride pyromellitique et de la 4,4'-oxydiphénylène diamine;
BDA-PDA qui vient de l'anhydride de bis-(phénylène acide dicarboxylique) et de la p-phénylènediamine;
ou BTDA-APB qui vient du dianhydride acide tétracarboxylique de benzophénone et du 1,3-bis-(2-aminphénoxy)benzène.

5. Composant ou circuit électronique selon l'une quelconque des revendications 2 à 4, caractérisé par un motif conducteur, généré dans le produit composite par irradiation avec un laser pulsé à U.V., puis exposition à un électroplacage au cuivre.

6. Composant ou circuit électronique selon l'une quelconque des revendications 2 à 5, caractérisé en ce que le matériau à base de carbone fluoruré contient jusqu'à 75 % en poids atomique de fluorure.

7. Composant ou circuit électronique selon l'une quelconque des revendications 2 à 6, caractérisé en ce que
la composition du matériau comprend un agent copulant pour augmenter la dispersion dudit matériau à base de carbone fluoruré dans le précurseur dudit matériau polyimide.

8. Composant ou circuit électronique selon la revendication 7, caractérisé en
ce que l'agent copulant est un composé organo-silicium ou bien un composé organo-titanium.

9. Un procédé de fabrication d'un circuit ou d'un composant électronique comprenant un matériau polymère polyimide selon l'une quelconque des revendications 2 à 8, caractérisé par la mise en dispersion du matériau à base de carbone particulaire fluoruré dans ledit matériau polymère polyimide en une quantité comprise dans la plage allant de 2 à 50 pour-cent en poids et chauffage dudit matériau composite à une température de 350 à 450 °C à une vitesse de 5 °C à 45 °C par minute, afin d'augmenter la constante diélectrique, ou chauffage rapide de ce produit, en particulier à une température de 400 °C, à une vitesse de 65 °C à 200 °C par seconde, pour diminuer la constante diélectrique.

10. Le procédé selon la revendication 9, caractérisé par
l'irradiation dudit matériau composite polyimide avec un laser U.V. pulsé pour former un matériau composite polyimide ayant au moins une zone conductrice en surface dans ledit matériau composite polyimide contenant un matériau à base de carbone fluorure.

11. Le procédé selon la revendication 10, caractérisé en ce que ledit matériau composite est irradié sélectivement avec ledit laser U.V. pulsé pour produire au moins une zone conductrice en surface en une position adjacente à une zone non conductrice dans ledit matériau composite.

12. Le procédé selon l'une quelconque des revendications 10 à 11, caractérisé par la formation d'un revêtement en métal électrolytique sur ladite zone conductrice en surface.
